# EUROPÄISCHE PATENTANMELDUNG

(11) **EP 2 634 798 A1**
(43) Veröffentlichungstag der Anmeldung: **04.09.2013**
(21) Anmeldenummer: 12157497.4
(22) Anmeldetag: 29.02.2012
(51) Int. Cl.: H01L 23/433

(54) **Elektrische Vorrichtung mit Kühlgehäuse**

(71) Anmelder: Siemens Aktiengesellschaft, 80333 München (DE)
(72) Erfinder: Schwarz, Norbert, 90455 Nürnberg (DE)

(57) **Zusammenfassung**

Die Erfindung betrifft eine elektrische Vorrichtung (100), umfassend ein Gehäuseteil (10), welches als ein Kühlgehäuse ausgestaltet ist zur Aufnahme eines ersten Wärmestroms von einem ersten Bauteil (1), mit
- einem ersten Übertragungsmittel (1a) zur Übertragung des ersten Wärmestromes in das Gehäuseteil (10),
dadurch gekennzeichnet, dass das erste Übertragungsmittel (1a) zwischen dem ersten Bauteil (1) und dem Gehäuseteil (10) angeordnet ist und einen Kolben (20) aufweist, wobei der Kolben (20) in einem Gegenstück steckt, welches im Gehäuseteil (10) angeordnet ist, und der Kolben (20) über einen Kolbenboden (21) den Wärmestrom von dem ersten Bauteil (1) aufnimmt und über eine Kolbenmantelfläche (22) an das Gegenstück weiterleitet.

## Beschreibung

Die Erfindung betrifft eine elektrische Vorrichtung, umfassend ein Gehäuseteil, welches als ein Kühlgehäuse ausgestaltet ist zur Aufnahme eines ersten Wärmestroms von einem ersten Bauteil mit einem ersten Übertragungsmittel zur Übertragung des ersten Wärmestroms in das Gehäuseteil.

Aufgrund einer Miniaturisierung von Elektronikkomponenten, wird zunehmend eine höhere Packungsdichte/Funktionsdichte an elektronischen Komponentenbauteilen auf einer Flachbaugruppe, wie beispielsweise eine bestückte Leiterplatte, realisiert. Dies führt zu einer Erhöhung der Verlustleistung, da eine Gerätefunktionalität und damit eine Anzahl der verwendeten elektronischen Bauteile steigen. Auch der Einsatz von höher getakteten Mikroprozessoren führt zu einem Anstieg der Verlustleistung. Bezogen auf eine Entwärmung von elektronischen Baugruppen besteht somit der Bedarf verbesserte Konzepte im Sinne der abzuführenden thermischen Verlustleistung bei gleichzeitiger optimaler Platzausnutzung zu entwickeln.

Nach dem derzeitigen Stand der Technik werden dazu elektronische Bauteile an eine Kühlplatte, einen Kühlkörper oder Gehäuseteilen thermisch kontaktiert. In vielen elektronischen Baugruppen oder Geräten besteht aus Platz- und Kostengründen die Notwendigkeit, mehrere elektronische Bauelemente an ein gemeinsames Kühlsystem thermisch kontaktieren.

In der EP 0 454 603 A2 wird ein Kühlsystem offenbart, bei welchem eine Mehrzahl von Computerchips über einen ersten rippenförmigen flexiblen Einsatz thermisch kontaktiert werden. Auf den ersten flexiblen Einsatz wird eine Gitterstruktur mit schräg gestellten Federarm aufgebracht und auf diese Gitterstruktur wird ein zweiter flexibler Einsatz aufgebracht, welcher thermisch mit einer Oberschale des Kühlsystems kontaktiert, wobei die Oberschale mit einer Unterschale des Kühlsystems fest verschraubt wird. Nachteilig an dieser Lösung ist es, dass für den Einsatz auf einer Leiterplatte drei Übertragungsmittel zwischen einem wärmeabgebenden Bauteil und einer Kühlplatte, oder einem Kühlgehäuse, oder einem Kühlkörper angeordnet werden müssten.

Bei der Kontaktierung von mehreren elektronischen Bauteilen an ein gemeinsames Kühlgehäuse besteht die Problematik, dass durch die vorhandenen Maßtoleranzen der elektronischen Bauteile, das Kühlgehäuse nicht alle elektronischen Bauteile gleichzeitig thermisch optimal kontaktieren kann. Beispielsweise haben zwei elektronische Bauteile, welche auf einer Leiterplatte angeordnet sind, eine unterschiedliche Höhendifferenz, die thermisch überbrückt werden muss. Dies wird üblicher Weise durch einen Gap-Filler, wie z.B. eine Wärmeleitpaste, und einem zusätzlichen Heatspreader, wie z.B. eine Aluminiumplatte, realisiert. Durch dieses Material, welche die Höhendifferenz ausgleicht, ist der thermische Entwärmungspfad zwar überbrückt aber nicht optimal ausgelegt.

Es ist Aufgabe der Erfindung, einen aufgrund unterschiedlicher Toleranzlagen von Bauteilen entstehenden thermischen Widerstand in einem thermischen Entwärmungspfad zu reduzieren und damit eine Gesamtentwärmung einer elektrischen Vorrichtung zu optimieren.

Die Aufgabe wird für die eingangs genannte Vorrichtung dadurch gelöst, dass das erste Übertragungsmittel zwischen dem ersten Bauteil und dem Gehäuseteil angeordnet ist und einen Kolben aufweist, wobei der Kolben in einem Gegenstück steckt, welches im Gehäuseteil angeordnet ist, und der Kolben über einen Kolbenboden den Wärmestrom von dem ersten Bauteil aufnimmt und über eine Kolbenmantelfläche an das Gegenstück weiterleitet. Mit einem in einem Gegenstück, vorzugsweise angeordnet im Gehäuseteil, beweglichen Kolben ist es nun möglich den thermischen Entwärmungspfad zu optimieren, insbesondere im Hinblick darauf, dass moderne Prozessoren nur eine relativ kleine zu kühlende Fläche aufweisen, teilweise liegt diese zu kühlende Fläche unter 1 qcm. Mit dem auf dem elektrischen Bauteil aufliegenden Kolbenboden ist es nun vorteilhaft möglich eine von dem elektrischen Bauteil abgegebene Wärme großflächig in das Gegenstück und damit in das Gehäuseteil bzw. das Kühlgehäuse zu verteilen.

Vorteilhafter Weise ist der Kolben und das Gegenstück zylindrisch ausgestaltet. Durch den Einsatz eines Kolbenzylindersystems kann nach dem Stand der Technik auf den Headspreader und den Gap-Filler verzichtet werden. Die in dem elektrischen Bauteil entstehende Wärme wird vorzugsweise direkt vom Kolbenboden aufgenommen und über eine Mantelfläche des zylindrisch ausgestalteten Kolbens sowie des zylindrisch ausgestalteten Gegenstücks an das Kühlgehäuse abgegeben. Das zylindrisch ausgestaltete Gegenstück wird mit seinem zylindrisch ausgestalteten Kolben über eine Passung vorteilhafter Weise parallel zu dem zu kühlenden Bauteil ausgerichtet.

Eine weitere Optimierung des thermischen Entwärmungspfades wird dadurch erreicht, dass der Kolbenboden mit einer Kolbenbodenaußenseite an dem ersten Bauteil angeordnet ist und an der entsprechenden Kolbenbodeninnenseite ein erstes Ende eines elastischen Elementes angeordnet ist, wobei ein zweites Ende des elastischen Elementes zum Gegenstück hin angeordnet ist. Als elastisches Element könnte beispielsweise eine Spiralfeder eingesetzt sein. Die Spiralfeder wirkt als ein Toleranzausgleich und drückt den zylindrisch ausgestalteten Kolben vorzugsweise mit einer konstanten Kraft gegen das zu kühlende Bauteil.

Die Vorrichtung mit den zylindrischen Kolben und dem zylindrischen Gegenstück wird weiter verbessert, wenn der Kolben derart ausgestaltet ist, dass auf dem Kolbenboden eine Wandung angeordnet ist und der Kolben dadurch becherförmig ausgestaltet ist, wobei das Gegenstück ebenfalls eine becherförmige Ausgestaltung mit einer Außenwandung und einer innerhalb der Außenwandung angeordneten Innenwandung aufweist, wobei die Wandung des Kolbens im Inneren des Gegenstücks zwischen der Außenwandung und der Innenwandung angeordnet ist. Durch die mehrfache Anordnung von Wandungen, mehrere ineinander verschachtelte Mantelflächen, wird der thermische Entwärmungspfad weiter verbessert, da nun quasi parallel über mehrere Flächen gleichzeitig der Wärmestrom abgeführt werden kann.

Zur Verbesserung einer Handhabung im Einbau bzw. in der Montage von elektrischen Vorrichtungen mit dem als zylindrischen Kolben und zylindrischen Gegenstück ausgestalteten Übertragungsmittel ist es von Vorteil, wenn die Wandung des Kolbens auf einer Umfangslinie einen Dichtungsring trägt. Der Dichtungsring kann beispielsweise als ein O-Ring ausgestaltet sein und auf den Kolben aufgeschoben sein, wobei zusätzlich der Kolben an der Stelle an der der Dichtungsring sitzen soll, eine umlaufende Vertiefung aufweist. Der O-Ring am Kolben hat somit die Aufgabe bei einer Montage ein unbeabsichtigtes Herausfallen des Kolbens aus dem Gegenstück zu verhindern.

Weist die Vorrichtung ein zweites Bauteil mit einem zweiten Übertragungsmittel zur Übertragung eines zweiten Wärmestroms in das Gehäuseteil auf, so macht sich der Toleranzausgleich mittels des zylindrisch ausgestalteten Kolbens und des zylindrisch ausgestalteten Gegenstücks besonders vorteilhaft bemerkbar. Ein auf die Gegenstücke aufgesetztes Gehäuseteil in Form eines Kühlgehäuses unterliegt auch Fertigungs- und Maßtoleranzen, die beiden federnd gelagerten Übertragungsmittel können die Maßtoleranzen somit ausgleichen und für beide Bauteile einen optimalen thermischen Entwärmungspfad gewährleisten.

Eine besonders vorteilhafte Ausgestaltung der Vorrichtung sieht vor, dass das Gehäuseteil als ein Aluminiumdruckgussteil ausgestaltet ist, welches eine Gehäuserückwandwanne für ein Bedien- und Beobachtungsgerät bildet.

Vorteilhafter Weise ist die Gehäuserückwandwanne in einem Randbereich der Wanne mit Befestigungspunkten zur Aufnahme einer Leiterplatte versehen, wobei auf einer Innenseite der Leiterplatte das erste und das zweite Bauteil und auf einer Außenseite der Leiterplatte ein Display angeordnet ist.

Die Zeichnung zeigt ein Ausführungsbeispiel einer elektrischen Vorrichtung mit Kühlgehäuse. Es zeigt die
- FIG 1: eine schematisch dargestellte elektrische Vorrichtung in einer Schnittdarstellung durch das Kühlgehäuse und durch die Übertragungsmittel zur Übertragung der Wärmeströme,
- FIG 2: ein Übertragungsmittel in Form eines zylindrischen Kolbens mit einem zylindrischen Gegenstück und
- FIG 3: das aus FIG 2 dargestellte Übertragungsmittel, wobei der Kolben aus dem zylindrischen Gegenstück herausgenommen ist.

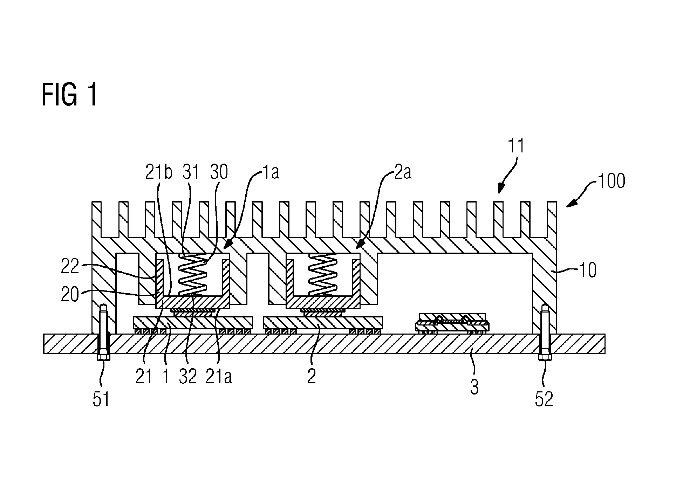

Gemäß FIG 1 ist eine elektrische Vorrichtung 100, umfassend ein Gehäuseteil 10, welches als ein Kühlgehäuse ausgestaltet ist, dargestellt. Das Kühlgehäuse weist in einer Schnittdarstellung linksseitig einen ersten Befestigungspunkt 51 und rechtsseitig einen zweiten Befestigungspunkt 52 auf, wobei mittels der Befestigungspunkte 51,52 eine Leiterplatte 3 an das Gehäuseteil 10 angeschraubt ist. Das Gehäuseteil 10 ist als ein Kühlgehäuse, beispielsweise aus Aluminiumdruckguss, mit Kühlrippen 11 ausgestaltet. Auf der Leiterplatte 3 ist ein erstes Bauteil 1 und ein zweites Bauteil 2 angeordnet. Ein erstes Übertragungsmittel 1a ist zwischen dem ersten Bauteil 1 und dem Gehäuseteil 10 angeordnet. Das Gehäuseteil 10 weist dazu eine zylindrische, buchsenförmige Aufnahme als ein Gegenstück für einen Kolben 20 auf. Der in dem Gegenstück steckende Kolben 20 nimmt über einen Kolbenboden 21 einen Wärmestrom von dem ersten Bauteil 1 auf und gibt diesen Wärmestrom über eine Kolbenmantelfläche 22 an das buchsenförmig ausgestaltete Gegenstück des Gehäuseteils 10 ab.

Der Kolbenboden 21 mit einer Kolbenbodenaußenseite 21 liegt über ein TIM-Pad (Terminal-Interface-Material (TIM)) auf dem ersten Bauteil 1 auf. Das TIM-Pad ist hier nur optional zu sehen, es ist genauso möglich das TIM-Pad wegzulassen.

Innerhalb des Kolbens 20 ist an einer Kolbenbodeninnenseite 21b ein erstes Ende 31 eines elastischen Elementes 30 angeordnet, wobei ein zweites Ende 32 des elastischen Elementes 30 zum Kühlgehäuse hin angeordnet ist. Das elastische Element 30 ist beispielsweise als eine Spiralfeder ausgestaltet und sorgt dafür, dass der Kolben 20 sich aus dem buchsenförmigen Gegenstück des Gehäuseteils mit einer konstanten Kraft herausdrückt und somit für eine sichere thermische Kontaktierung auf dem ersten Bauteil 1 aufliegt.

Der zuvor beschriebene Aufbau mit dem zylindrisch ausgestalteten Kolben und dem in dem Gehäuseteil 10 angeordneten Gegenstück, welche beide zusammen das erste Übertragungsmittel 1a bilden, gilt ähnlich für das zweite Übertragungsmittel 2a, welches für eine Entwärmung des zweiten Bauteils 2 sorgt.

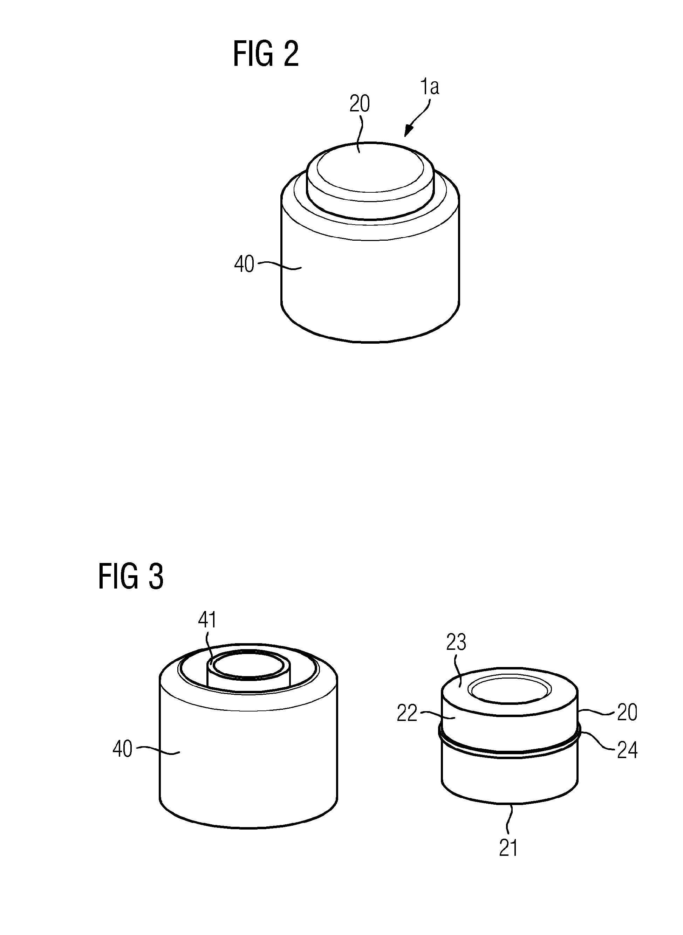

Gemäß der FIG 2 ist ein als zylindrischer Kolben 20, welcher in einem Gegenstück mit einer Außenwandung 20 steckt, dargestellt, wobei diese Anordnung das erste Übertragungsmittel 1a bildet. Ein Vorteil dieser Ausgestaltung eines "Thermozylinders" ist es, dass er in der Fertigung als ein Drehteil einfach und kostengünstig herzustellen ist. Eine Befestigung an der Leiterplatte 3 kann entfallen, da es über eine Passung in die entsprechende becherförmige Ausgestaltung innerhalb des Gehäuseteils 10 angeordnet ist.

Mit der FIG 3 ist das aus FIG 2 dargestellt Übertragungsmittel 1a zweiteilig dargestellt. Der Kolben 20 mit seinem Kolbenboden 21 und seiner Kolbenmantelfläche 22 ist aus dem Gegenstück herausgenommen. Die Wandung 23 des Kolbens trägt auf einer Umfanglinie einen O-Ring. Das Gegenstück ist mit einer Außenwandung 40 und einer Innenwandung 41 ausgestaltet und die Durchmessermaße der Außen- und Innenwandung lassen eine exakte Passung bei eingesteckten Kolben 20 zu. Über die doppelt ausgestalteten Mantelflächen von der Außenwandung 40 und der Innenwandung 41 erhält man eine Parallelisierung eines thermischen Entwärmungspfades und die Entwärmung über das erste Übertragungsmittel 1a wird somit optimiert.

## Patentansprüche

1. Elektrische Vorrichtung (100) umfassend ein Gehäuseteil (10), welches als ein Kühlgehäuse ausgestaltet ist zur Aufnahme eines ersten Wärmestroms von einem ersten Bauteil (1), mit
- einem ersten Übertragungsmittel (1a) zur Übertragung des ersten Wärmestromes in das Gehäuseteil (10),
**dadurch gekennzeichnet, dass** das erste Übertragungsmittel (1a) zwischen dem ersten Bauteil (1) und dem Gehäuseteil (10) angeordnet ist und einen Kolben (20) aufweist, wobei der Kolben (20) in einem Gegenstück steckt, welches im Gehäuseteil (10) angeordnet ist, und der Kolben (20) über einen Kolbenboden (21) den Wärmestrom von dem ersten Bauteil (1) aufnimmt und über eine Kolbenmantelfläche (22) an das Gegenstück weiterleitet.

2. Vorrichtung nach Anspruch 1, wobei der Kolben (20) und das Gegenstück zylindrisch ausgestaltet sind.

3. Vorrichtung nach Anspruch 1 oder 2, wobei der Kolbenboden (21) mit einer Kolbenbodenaußenseite (21a) an dem ersten Bauteil (1) angeordnet ist und an der entsprechenden Kolbenbodeninnenseite (21b) ein erstes Ende (31) eines elastischen Elementes (30) angeordnet ist, wobei ein zweites Ende (32) des elastischen Elementes (30) zum Gegenstück hin angeordnet ist.

4. Vorrichtung nach Anspruch 2 oder 3, wobei der Kolben (20) derart ausgestaltet ist, dass auf dem Kolbenboden (21) eine Wandung (23) angeordnet ist und der Kolben (20) dadurch becherförmig ausgestaltet ist, wobei das Gegenstück ebenfalls eine becherförmige Ausgestaltung mit einer Außenwandung (40) und einer innerhalb der Außenwandung (40) angeordneten Innenwandung (41) aufweist, wobei die Wandung (23) des Kolbens (20) im inneren des Gegenstücks zwischen der Außenwandung (40) und der Innenwandung (41) angeordnet ist.

5. Vorrichtung nach Anspruch 4, wobei die Wandung (23) des Kolbens (20) auf einer Umfangslinie einen Dichtungsring (24) trägt.

6. Vorrichtung nach einem der Ansprüche 1 bis 5,
aufweisend ein zweites Bauteil (2), mit
- einem zweiten Übertragungsmittel (2a) zur Übertragung eines zweiten Wärmestromes in das Gehäuseteil (10).

7. Vorrichtung nach einem der Ansprüche 1 bis 6, wobei das Gehäuseteil (10) als ein Aluminiumdruckgussteil ausgestaltet ist, welches eine Gehäuserückwandwanne für ein Bedien-/ und Beobachtungsgerät bildet.

8. Vorrichtung nach Anspruch 7, wobei die Gehäuserückwandwanne in einem Randbereich der Wanne Befestigungspunkte (51,52) zur Aufnahme einer Leiterplatte (3) aufweist, wobei auf einer Innenseite der Leiterplatte (3) das erste und das zweite Bauteil (1,2) und auf einer Außenseite der Leiterplatte (3) ein Display angeordnet ist.
